# EUROPÄISCHE PATENTANMELDUNG

(11) **EP 0 939 583 A2**
(43) Veröffentlichungstag der Anmeldung: **01.09.1999**
(21) Anmeldenummer: 99103577.5
(22) Anmeldetag: 24.02.1999
(51) Int. Cl.: H05K 13/04, H05K 3/34, H05K 13/00, B23K 3/06

(54) **Anordnung zur Bestückung von Leiterplatten mit integrierten Schaltungen**

(30) Priorität: 26.02.1998 DE 19808171
(71) Anmelder: Resma GmbH, 38640 Goslar (DE)
(72) Erfinder: Pachschwöll, Heino, 34477 Twistetal (DE)
(74) Vertreter: Manitz, Finsterwald & Partner

(57) **Zusammenfassung**

Anordnung zur Bestückung von Leiterplatten (4) mit oberflächenmontierbaren Bauteilen (9), insbesondere integrierten Schaltungen, mit Mitteln (1, 3) zur Halterung der Leiterplatten (4) in einer vorbestimmten Position, Mitteln (5, 6) zum Auftragen von Lotpaste auf die Kontaktierungsstellen (8) der Leiterplatte (4) für die Anschlußkontakte der Bauteile (9) und Mitteln (10, 11) zum Aufsetzen der Bauteile (9) auf die Leiterplatte (4), wobei zur Ermöglichung von Kleinserien mit geringem Kosten- und Zeitaufwand für jede Leiterplattentype eine an diese angepaßte Halterung (1, 3) vorgesehen ist und wobei diese Halterungen (1, 3) lösbar auf einem Basisträger (2) montierbar sind.

## Beschreibung

Die vorliegende Erfindung betrifft eine Anordnung zur Bestückung von Leiterplatten mit oberflächenmontierbaren Bauteilen, insbesondere integrierten Schaltungen, mit Mitteln zur Halterung der Leiterplatten in einer vorbestimmten Position, Mitteln zum Auftragen von Lotpaste auf die Kontaktierungsstellen der Leiterplatte für die Anschlußkontakte der Bauteile und Mitteln zum Aufsetzen der Bauteile auf die Leiterplatte.

Aufgrund des Fertigungsablaufes müssen oberflächenmontierbare Bausteine wie integrierte Schaltungen vor dem jeweiligen Lötprozeß und/oder einem anderweitigem Fügeprozeß einzeln auf die Leiterplatten oder auf entsprechend gestaltete Träger aufgesetzt werden. Dazu müssen an den vorgesehenen Kontaktierungsstellen die Löt- bzw. Fügepunkte vor dem Aufbringen des Bausteins mit einem Medium, beispielsweise Lotpaste oder einem für die Fügeaufgabe vorgesehenen Medium, beispielsweise Klebstoff, versehen werden. Anschließend muß der Baustein mit seinen Anschlußelementen zielgenau auf die mit dem Medium benetzten Lötpunkte auf der Leiterplatte aufgesetzt werden.

Das Aufbringen des Mediums und das Aufsetzen der Bausteine kann weitgehend automatisiert erfolgen, wenn die jeweiligen Positionen festgelegt sind. Bei Großserien ist es kein Problem, diese Positionen festzulegen und im Falle der Lotpaste die Lotpastenauftragmittel sowie die Bauteilbestückungsmittel auf diese Positionen einzustellen. Bei Kleinserien ist dies jedoch ein erheblicher Kostenfaktor. Auch ist das Einstellen auf verschiedene Leiterplattentypen zeitaufwendig und erfordert in der Regel speziell ausgebildetes Personal.

Der Erfindung liegt die Aufgabe zugrunde, die Anordnung der eingangs genannten Art so auszubilden, daß auch Kleinserien kostengünstig und mit geringem Zeitaufwand ausgeführt werden können.

Diese Aufgabe wird dadurch gelöst, daß für jede Leiterplattentype eine an diese angepaßte Halterung vorgesehen ist und daß diese Halterungen lösbar auf einem Basisträger montierbar sind.

Durch die Verwendung eines Basisträgers, auf welchem an die verschiedenen Leiterplattentypen angepaßte Halterungen lösbar montierbar sind, kann die erfindungsgemäße Anordnung schnell und kostengünstig umgerüstet werden. Bei einem Serienwechsel muß lediglich die vorhandene Halterung von dem Basisträger entfernt und die an die neue Serie angepaßte Halterung auf dem Basisträger montiert werden. Dies kann auch durch nicht spezialisiertes Personal vorgenommen werden, so daß ein Serienwechsel schnell erfolgen kann. Darüber hinaus muß lediglich für jede Leiterplattentype eine Halterung bevorratet werden, während im übrigen grundsätzlich dieselben Mittel verwendet werden können. Daher können auch Kleinserien kostengünstig mit der erfindungsgemäßen Anordnung ausgeführt werden.

Nach einer Ausgestaltung der Erfindung ist der Basisträger zwischen verschiedenen Bearbeitungspositionen verschiebbar. Die Verschiebung erfolgt dabei bevorzugt über einen Schlitten, auf den der Basisträger aufgesetzt sein kann. Die verschiedenen Bearbeitungsschritte können dadurch räumlich auseinandergezogen werden, wodurch sich die Anordnung der Bearbeitungsmittel vereinfacht.

Beispielsweise kann der Basisträger zwischen einer Leiterplatteneinsetzstation, einer Lotpastenauftragstation, einer Bauteilbestückungsstation und einer Leiterplattenentnahmestation verschiebbar sein. Dabei ist es bevorzugt, wenn der Basisträger in der Lotpastenauftragposition und in der Bauteilbestückungsposition arretierbar ist. Hierdurch wird sichergestellt, daß sich die Leiterplatten und damit die Kontaktierungsstellen stets in einer festgelegten Position befinden.

Als Halterung ist bevorzugt eine Aufnahmeplatte mit die Position der Leiterplatte festlegenden Anschlägen oder Indexstiften vorgesehen. In konstruktiv unaufwendiger Weise wird hierdurch eine Positionierung der Leiterplatten mit geringer Toleranz ermöglicht. Einlegen und Entnehmen der Leiterplatten sind außerdem einfach.

Nach einer weiteren Ausgestaltung der Erfindung umfassen die Mittel zum Auftragen des Mediums eine Verfahreinheit mit einem Auftragkopf. Der Auftragkopf kann dabei über die Verfahreinheit nacheinander zu den einzelnen Kontaktierungsstellen verfahrbar sein. Der Auftragkopf kann aber auch mehrere hinsichtlich der Anzahl und der Anordnung an die jeweiligen Kontaktierungsstellen eines oder mehrerer Bauteile angepaßte Auftragspitzen aufweisen. In diesem Fall werden die genannten Kontaktierungsstellen gleichzeitig mit dem Medium versehen.

Bevorzugt ist es dabei, wenn der Auftragkopf lösbar mit der Transporteinheit verbindbar ist. Durch die Lösbarkeit wird wiederum ein schneller Wechsel des Auftragkopfes und damit eine einfache Umstellung auf andere Bauteile ermöglicht.

Beispielsweise kann der Auftragkopf mit einer Mehrzahl von Nadeln versehen sein, die mittels der Verfahreinheit in ein Lotpastendepot eintauchbar und anschließend zu den zugehörigen Kontaktierungsstellen auf der Leiterplatte verfahrbar sind. Das Lotpastendepot kann dabei als Mulde mit Rakeleinheit ausgebildet sein, in welche die Nadeln mit einer vorbestimmten Eintauchtiefe eintauchen. Der beim Herausziehen an den Nadeln jeweils anhaftende Tropfen bestimmt dann die aufgetragene Lotpastenmenge.

Nach einer weiteren Ausgestaltung der Erfindung, die auch für sich beansprucht wird, sind die Nadeln jedoch als an ihrer Spitze offene Hohlnadeln ausgebildet und weisen einen innerhalb der Nadel zwischen einer ersten Position und einer zweiten Position verschiebbar und dichtend geführten Kolben auf, der mit der Nadel einen über die offene Nadelspitze zugänglichen, volumenveränderlichen Aufnahmeraum für das Medium, beispielsweise Lotpaste bildet. Durch diese Ausgestaltung kann die Lotpastenmenge sehr genau dosiert werden, insbesondere wenn Mittel vorgesehen sind, durch welche außen an der Nadel anhaftende Lotpaste oder an der Nadelspitze ausgebildete Lotpastentropfen vermeidbar oder entfernbar sind. Die Lotpastenmenge wird bei dieser Vorrichtung dann exakt durch den Kolbenhub bestimmt.

Diese Ausgestaltung hat zudem den Vorteil, daß die aufgenommene Lotpastenmenge unabhängig von der Eintauchtiefe der Nadel in die Lotpaste ist und daß die Dosiermenge nicht mehr von der Oberflächenbeschaffenheit der Nadel und den Eigenschaften oder dem Zustand des Mediums abhängt. Um ein Anhängen von Lotpaste an der Außenseite der Nadel oder eine Tropfenbildung an der Spitze der Nadel zu verhindern, können beispielsweise Abstreif-, Abblas- oder Abspülmittel vorgesehen sein. Nach einer weiteren Ausgestaltung der Erfindung ist der Kolben mit seinem zur Nadelspitze weisenden Ende aus der Nadel ausfahrbar. Durch Ausfahren des Kolbenendes beim Eintauchen der Nadelspitze in die Lotpaste wird eine sichere Anbindung der Lotpaste an den Nadelkolben gewährleistet und die Ausbildung einer Luftblase in der Nadel verhindert.

Nach einer weiteren Ausgestaltung der Erfindung ist der Kolben innerhalb der Nadel in mindestens eine weitere Position verschiebbar, um ein zusätzliches Aufnahmevolumen zu schaffen. Auf diese Weise kann die Nadel nacheinander mit zwei oder mehreren Stoffen gefüllt werden, die dann gemeinsam auf die vorgesehenen Positionen abgesetzt werden können. Eine Mehrstoffüllung kann außerdem dadurch erreicht werden, daß zusätzlich zu der Füllung des durch die Nadel und den Kolben gebildeten Aufnahmeraumes ein Tropfen an der Nadelspitze durch Eintauchen der gefüllten Nadel in einen weiteren Stoff ausgebildet wird.

Nach einer weiteren Ausgestaltung der Erfindung sind Mittel zur Erzeugung von Vibrationen der Nadel, insbesondere Ultraschallerzeuger, und/oder Mittel zur Erwärmung der Nadel vorgesehen. Hierdurch kann die Benetzung und/oder Füllung der Nadel verbessert werden. Über eine Erwärmung kann beispielsweise die Viskosität der Flüssigkeit verändert werden. Es können aber auch andere physikalische oder chemische Effekte ausgenutzt werden, beispielsweise eine Thixotropie des Mediums.

Nach einer weiteren Ausgestaltung der Erfindung umfassen die Bestükkungsmittel eine Verfahreinheit mit einem Bestückungskopf, welcher bevorzugt an verschiedene Bauteiltypen anpaßbar ist. Auch durch diese Ausgestaltung wird der Serienwechsel erleichtert und verbilligt. Bevorzugt ist es, wenn Mittel zum automatischen Auftragen der Lotpaste und/oder zum automatischen Bestücken der Leiterplatten mit Bauteilen vorgesehen sind. Das Einlegen und/oder Entnehmen der Leiterplatten aus der Aufnahme erfolgt dagegen bevorzugt manuell. Auch das Verschieben der Leiterplatte zwischen den einzelnen Bearbeitungsstationen erfolgt bevorzugt manuell. Insgesamt ergibt sich damit eine halbautomatische Anordnung, die trotz niedriger Kosten eine schnelle und sichere Bestückung ermöglicht.

Nach einer weiteren Ausgestaltung der Erfindung ist die Anordnung zumindest weitgehend aus an sich bekannten Einheiten und modular aufgebaut. Der Aufbau der Anordnung ist dadurch kostengünstig. Außerdem können die einzelnen Bestandteile später anderweitig weiter verwendet werden.

Ein Ausführungsbeispiel der Erfindung ist in der Zeichnung dargestellt und wird nachfolgend beschrieben. Es zeigen, jeweils in schematischer Darstellung,
- Fig. 1: eine Draufsicht auf eine erfindungsgemäße Anordnung,
- Fig. 2a - d: eine erfindungsgemäße Dosiereinrichtung in vier verschiedenen Arbeitspositionen,
- Fig. 3a - b: die Dosiereinrichtung von Fig. 2 in zwei weiteren Arbeitspositionen, und
- Fig. 4: ein Depotsystem für die erfindungsgemäße Dosiereinrichtung.

Nachfolgend wird die vorliegende Erfindung rein beispielhaft anhand der Verwendung von Lotpaste als Medium beschrieben. Es wird jedoch darauf hingewiesen, daß die Erfindung genauso die Applikation von Klebstoffen und dergleichen umfaßt.

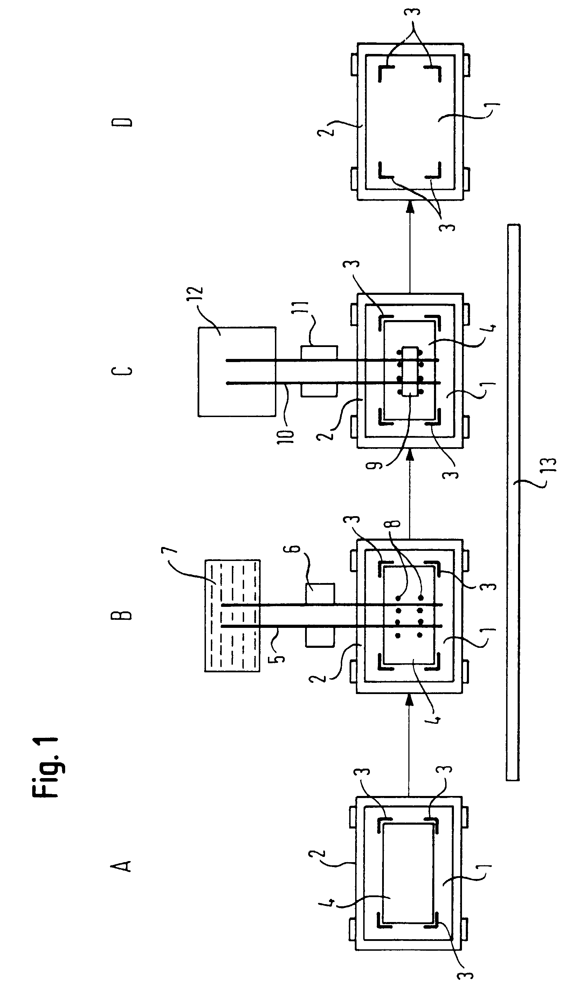

Die in Fig. 1 gezeigte Anordnung umfaßt eine Aufnahmeplatte 1, die mit einem als Schlitten ausgebildeten Basisträger 2 lösbar verbunden ist. Auf der Aufnahmeplatte 1 sind Anschläge 3 angeordnet, zwischen die eine Leiterplatte 4 paßgenau einsetzbar ist. Über den als Schlitten ausgebildeten Basisträger 2 sind die Leiterplatten 4 zwischen Bearbeitungsstationen A, B, C und D verschiebbar.

Die erste Bearbeitungsstation A ist als Leiterplatteneinsetzstation ausgebildet, in welcher die Leiterplatten 4 in die Aufnahmeplatte 1 eingesetzt werden. Die eingesetzten Leiterplatten 4 werden über den Basisträger 2 anschließend in eine Lotpastenauftragstation B verfahren. Die Lotpastenauftrag-station B umfaßt eine Horizontalfördereinheit 5, mittels welcher ein Auftragkopf 6 zwischen einem Lotpastendepot 7 und der Leiterplatte 4 verfahrbar ist. Außerdem sind Arretiermittel vorgesehen, um den Basisträger 2 in einer vorbestimmten Position zu arretieren. Der Auftragkopf 6 weist an seiner Unterseite eine Vielzahl von Nadeln auf, die mit ihren Spitzen in das Lotpastendepot 7 eintauchbar und über der Leiterplatte 4 so weit absenkbar sind, daß die von den Nadeln aufgenommene Lotpaste auf die Kontaktierungsstellen 8 der Leiterplatte 4 abgesetzt werden kann. Die Nadeln sind dabei an dem Auftragkopf 6 in einer Anzahl und Anordnung vorhanden, die den Kontaktierungsstellen 8 des auf der Leiterplatte 4 anzubringenden Bauteils 9 entsprechen.

Nach beendetem Lotpastenauftrag wird die Arretierung gelöst und der Basisträger 2 mit der Leiterplatte 4 in die Bauteilbestückungsstation C verfahren. Die Bauteilbestückungsstation C ist wiederum mit einer Horizontalfördereinheit 10 versehen, durch welche ein Bestückungskopf 11 zwischen einem Bauteilmagazin 12 und der Leiterplatte 4 verfahrbar ist. Außerdem ist in der Bauteilbestückungsstation C ebenfalls eine Arretiervorrichtung zur Arretierung des Basisträgers 2 in einer vorbestimmten Position vorhanden. Der Bestückungskopf 11 kann beispielsweise eine Saugpipette zur Aufnahme der Bauteile 9 umfassen sowie eine Zentriereinheit, um die aufgenommenen Bauteile 9 vor dem Aufsetzen auf die Leiterplatte 4 zu zentrieren. Der Bestückungskopf 11 ist dabei so ausgebildet, daß verschiedene Bauteile 9 von ihm aufgenommen werden können.

Nach beendeter Bestückung der Leiterplatte 4 wird der Basisträger 2 in die Leiterplattenentnahmestation D verfahren. Hier kann die fertig bestückte Leiterplatte 4 von der Aufnahmeplatte 1 entnommen werden. Des weiteren ist, wie mit 13 angedeutet, im Bereich der Bearbeitungsstationen B und C eine Schutzverkleidung vorgesehen. Hierbei kann es sich insbesondere um einen Aluminiumrahmen mit Makrolonverglasung handeln, die einen freien Einblick auf den Arbeitsablauf ermöglicht.

Zur Bestückung einer Leiterplatte 4 wird diese in der Leiterplatteneinlegestation A zwischen die Anschläge 3 der Aufnahmeplatte 1 eingelegt. Anschließend wird die Aufnahmeplatte 1 mit der Leiterplatte 4 durch manuelles Verschieben des Basisträgers 2 in die Lotpastenauftragsstation B verfahren und dort eingerastet. Über einen Schalter wird nun der Lotpastenauftragvorgang aktiviert. Hierfür fährt der Auftragkopf 6 über das Lotdepot 7 und senkt sich soweit ab, daß die Nadeln eine gewünschte Menge Lotpaste aufnehmen können. Anschließend verfährt der Auftragkopf 6 über die Leiterplatte 4 und senkt sich wiederum ab, bis die Lotpaste auf den Kontaktierungsstellen 8 der Leiterplatte 4 abgegeben werden kann.

Nach Zurückfahren des Auftragkopfes 6 wird der Basisträger 2 mit der Leiterplatte 4 in die Bestückungsstation C verfahren und wiederum eingerastet. Durch Schalterbetätigung wird dann der Bestückungsvorgang aktiviert. Hierfür verfährt der Bestückungskopf 11 über das Bauteilmagazin 12 und senkt sich zur Aufnahme eines Bauteils 9 ab. Anschließend verfährt der Bestückungskopf 11 über die Leiterplatte 4 und setzt das Bauteil 9 in der vorgesehenen Position auf der Leiterplatte 4 ab. Nun kann der Basisträger 2 wieder ausgerastet und anschließend in die Leiterplattenentnahmestation D verfahren werden, wo die Leiterplatte 4 von Hand entnommen wird.

Der beschriebene Bestückungsvorgang setzt sich also aus manuellen und automatischen Arbeitsschritten zusammen. Dies ist insbesondere bei Kleinserien vorteilhaft. Durch die Aufnahmeplatte 1 mit den Anschlägen 3, die auf dem Basisträger 2 lösbar befestigt ist, ist die Position der Leiterplatte 4 relativ zum Basisträger 2 festgelegt. Dieser wiederum ist durch die Arretierung in den Bearbeitungsstationen B und C stets gleichbleibend positioniert, so daß der Lotpastenauftrag und die Bauteilbestückung sehr exakt ausgeführt werden können.

Die erfindungsgemäße Anordnung kann in einfacher Weise und schnell zur Bestückung verschiedener Leiterplattentypen ausgelegt werden. Hierfür wird die Aufnahmeplatte 1 vom Basisträger 2 gelöst und durch eine andere Aufnahmeplatte 1 ersetzt, die an die zu bestückende Leiterplatte 4 angepaßt ist, also dieser entsprechende Anschläge 3 aufweist. Ebenso kann der Auftragkopf 6 ausgewechselt werden, wenn die Leiterplatte 1 mit einem andersartigen Bauteil 6 bestückt werden soll. Ein Austausch des Bestückungskopfes 11 ist in der Regel nicht erforderlich, da dieser zur Aufnahme verschiedenartiger Bauteile 9 ausgebildet ist. Aufgrund dieser einfachen Anpaßbarkeit der Anordnung können mit dieser kostengünstig auch Kleinserien ausgeführt werden.

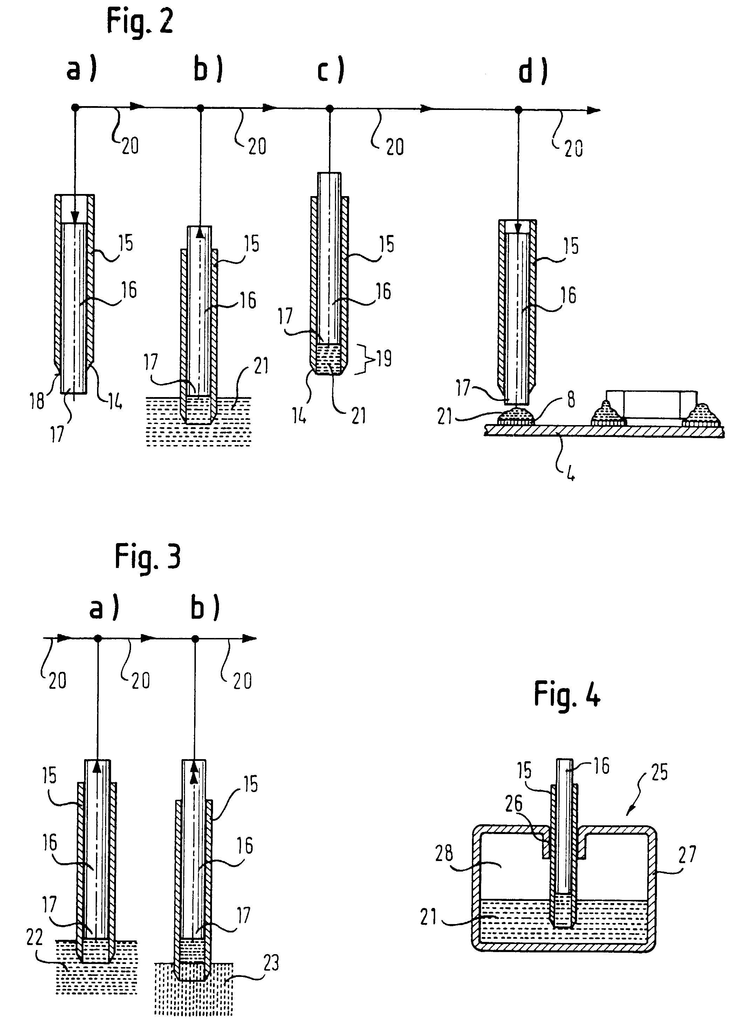

Die in den Figuren 2 und 3 dargestellte erfindungsgemäße Dosiervorrichtung umfaßt eine an ihrer Spitze 14 offene Hohlnadel 15, in welcher ein Kolben 16 zwischen einer ersten Stellung und einer zweiten Stellung verschiebbar und dichtend geführt ist. In der in Figur 2a dargestellten ersten Position des Kolbens 16 ragt dieser mit seinem zur Spitze 14 der Hohlnadel 15 weisenden Ende 17 aus der Nadelöffnung 18 heraus. In der in Figur 2c dargestellten zweiten Position ist das Ende 17 des Kolbens 16 gegenüber der Nadelöffnung 18 dagegen in das Nadelinnere zurückversetzt und bildet zusammen mit der Hohlnadel 15 einen Aufnahmeraum 19 für das zu dosierende Medium.

Über eine nur durch Pfeile 20 angedeutete Verfahreinrichtung ist die Hohlnadel 15 zwischen verschiedenen Stationen verfahrbar. Insbesondere ist die Hohlnadel 15, wie in Figur 2b dargestellt, in das zu dosierende Medium 21 eintauchbar, beispielsweise in ein Lotpastendepot. Von dort ist die Hohlnadel 15 zu einer Absetzposition verfahrbar, beispielsweise in die in Figur 2d dargestellte Lotpastenauftragstation, in welcher eine Leiterplatte 4 angeordnet ist.

Die Dosierung von Lotpaste mit der erfindungsgemäßen Dosiervorrichtung erfolgt in der nachfolgend beschriebenen Weise. Zunächst wird der Kolben 16 mit seinem Ende 17 aus der Hohlnadel 15 ausgefahren. In dieser Stellung wird die Hohlnadel 15 in die Lotpaste 21 eingetaucht und bei eingetauchter Hohlnadel 15 der Kolben 16 in seine zweite, zurückgezogene Stellung verfahren. Hierbei wird Lotpaste 21 in den durch den Kolben 16 und die Hohlnadel gebildeten Aufnahmeraum 19 gesaugt.

Nun wird die Hohlnadel 15 aus der Lotpaste 21 herausgezogen. Die in dem Aufnahmeraum 19 vorhandene Lotpastenteilmenge bleibt dabei aufgrund der Abdichtung des Kolbens 16 innerhalb der Nadel 15 in dem Aufnahmeraum 19 gehalten. Nun wird die Hohlnadel 15 über die Kontaktierungsstelle 8 auf der Leiterplatte 4 verfahren. Nach Absenken der Hohlnadel 15 wird der Kolben 16 aus der Hohlnadel 15 ausgefahren und die Lotpastenteilmenge aus dem Aufnahmeraum 19 auf die Kontaktierungsstelle 8 abgesetzt. Anschließend kann mit der erfindungsgemäßen Dosiereinrichtung erneut eine Lotpastenteilmenge aufgenommen und auf eine weitere Kontaktierungsstelle abgesetzt werden.

Wie in Figur 3 dargestellt, können mit der Hohlnadel 15 auch zwei oder mehr Medien aufgenommen werden. Hierfür wird die Hohlnadel zunächst in der vorbeschriebenen Weise in ein erstes Medium eingetaucht und eine Teilmenge dieses Mediums durch Zurückfahren des Kolbens 16 in seine zweite Stellung aufgenommen. Nach Herausziehen der Hohlnadel 15 aus dem ersten Medium 22 wird die Hohlnadel 15 in ein zweites Medium 23 getaucht. Nun wird der Kolben 16 in eine dritte, noch weiter in die Hohlnadel 15 zurückgezogene Stellung verfahren und dadurch auch eine Teilmenge des zweiten Mediums 23 in die Hohlnadel 15 gesaugt. Nach Herausziehen der Hohlnadel 15 aus dem zweiten Medium 23 können die beiden Mediumteilmengen in der zuvor beschriebenen Weise auf eine gewünschte Position abgesetzt werden. Bei den Medien kann es sich beispielsweise neben Lotpaste um Beiz-, Löse-, Netz- oder Reaktionsmittel handeln. Es können grundsätzlich in der beschriebenen Weise auch mehr als zwei Mediumteilmengen von der Hohlnadel 15 aufgenommen werden.

Nicht dargestellt sind Mittel, durch welche an der Außenseite der Hohlnadel anhängendes Medium oder an der Spitze 14 der Hohlnadel 15 gebildete Mediumtropfen entfernt werden können, damit die aufgenommene Mediumteilmenge ausschließlich durch den Aufnahmeraum 19 bestimmt wird. Dies können Abstreif-, Abblas- oder Abspülmittel sein. Es ist aber auch möglich, eine weitere Mediumteilmenge durch bewußtes Anhängen an die Außenseite der Hohlnadel 15 oder durch Tropfenbildung an der Spitze 14 der Hohlnadel 15 aufzunehmen. Ebenfalls nicht dargestellt sind außerdem Mittel, durch welche die Hohlnadel 15 in Vibrationen versetzt oder erwärmt werden kann, um die Aufnahme des Mediums in den Aufnahmeraum 19 zu unterstützen. Dies können beispielsweise Ultraschallerzeuger sein. Durch eine Erwärmung können chemische und/oder physikalische Effekte ausgenutzt werden, beispielsweise um die Klebrigkeit, Thixotropie oder Viskosität des Mediums zu verändern.

Bei Verwendung von Klebstoffen, insbesondere von leitenden Klebstoffen, kann zusätzlich durch einen Energieeintrag die Benetzungsintensität zu den Oberflächen gesteigert werden. Außerdem können Effekte erzielt werden, die eine Aushärtung eines Klebstoffes, zum Beispiel die Polymerisation, beeinflussen.

Fig. 4 zeigt die geschnittene Seitenansicht eines Depotsystems 25, in das die Nadel 15 bzw. mehrere Nadeln über dichtende Öffnungen 26 in ein Druckgefäß 27 eintauchen. In dem durch das Druckgefäß 27 gebildeten Innenraum 28 ist ein Reservoir für das aufzubringende Medium 21 gebildet. Der Behälter 27 kann nach dem Eintauchen vorzugsweise gepulst unter Druck gesetzt werden. Zudem sind die in dieser Anmeldung beschriebenen anderen Energieeinträge wie beispielsweise Ultraschall, Wärme und dergleichen simultan oder abwechselnd möglich.

### Bezugszeichenliste

- 1: Aufnahmeplatte
- 2: Basisträger
- 3: Anschlag
- 4: Leiterplatte
- 5: Horizontalfördereinheit
- 6: Auftragkopf
- 7: Lotpastendepot
- 8: Kontaktierungsstelle
- 9: Bauteil
- 10: Horizontalfördereinheit
- 11: Bestückungskopf
- 12: Bauteilmagazin
- 13: Schutzverkleidung
- 14: Nadelspitze
- 15: Hohlnadel
- 16: Kolben
- 17: Ende von 16
- 18: Nadelöffnung
- 19: Aufnahmenvolumen
- 20: Pfeil
- 21: Medium
- 22: erstes Medium
- 23: zweites Medium
- 25: Depotsystem
- 26: definierte Öffnung
- 27: Behälter
- 28: Behälterinneres
- A: Leiterplatteneinlegestation
- B: Lotpastenauftragstation
- C: Bauteilbestückungsstation
- D: Leiterplattenentnahmestation

## Patentansprüche

1. Anordnung zur Bestückung von Leiterplatten (4) mit oberflächenmontierbaren Bauteilen (9), insbesondere integrierten Schaltungen, mit Mitteln (1, 3) zur Halterung der Leiterplatten (4) in einer vorbestimmten Position, Mitteln (5, 6) zum Auftragen eines Mediums auf die Leiterplatte (4) und Mitteln (10, 11) zum Aufsetzen der Bauteile (9) auf die Leiterplatte (4),
dadurch **gekennzeichnet,**
daß für jede Leiterplattentype eine an diese angepaßte Halterung (1, 3) vorgesehen ist und daß diese Halterungen (1, 3) lösbar auf einem Basisträger (2) montierbar sind.

2. Anordnung nach Anspruch 1,
dadurch **gekennzeichnet,**
daß der Basisträger (2) zwischen verschiedenen Bearbeitungspositionen (A, B, C, D), insbesondere zwischen einer Leiterplatteneinsetzstation (A), einer Lotpastenauftragstation (B), einer Bauteilbestückungsstation (C) und einer Leiterplattenentnahmestation (D), beispielsweise mittels eines Schlittens, verschiebbar ist, wobei der Basisträger (2) in der Lotpastenauftragstation (B) und in der Bauteilbestückungsposition (C) bevorzugt arretierbar ist.

3. Anordnung nach Anspruch 1 oder 2,
dadurch **gekennzeichnet,**
daß als Halterung eine Aufnahmeplatte (1) mit die Position der Leiterplatte (4) festlegenden Anschlägen (3) oder Indexstiften vorgesehen ist.

4. Anordnung nach einem der vorhergehenden Ansprüche,
dadurch **gekennzeichnet,**
daß die Mittel zum Auftragen des Mediums eine Verfahreinheit (5) mit einem insbesondere lösbar mit dieser verbundenen Auftragkopf (6) umfassen, welcher insbesondere nacheinander zu Kontaktierungsstellen (8) auf der Leiterplatte (4) verfahrbar ist und bevorzugt mehrere hinsichtlich der Anzahl und der Anordnung an die jeweiligen Kontaktierungsstellen (8) eines oder mehrerer Bauteile (9) angepaßte Auftragspitzen aufweist, wobei der Auftragkopf (6) bevorzugt über ein Mehrachssystem, vorzugsweise programmiert, in die gewünschten Positionen bringbar ist.

5. Dosiereinrichtung zum Dosieren flüssiger oder pastöser Medien aus einem Vorratsbehälter mit mindestens einer mit ihrer Spitze (14) in den Vorratsbehälter eintauchbaren Nadel (15), durch welche eine Teilmenge des Mediums aufnehmbar ist, insbesondere zur Verwendung in einer Vorrichtung nach einem der vorhergehenden Ansprüche,
dadurch **gekennzeichnet,**
daß die Nadel (15) als an ihrer Spitze (14) offene Hohlnadel ausgebildet ist und einen innerhalb der Nadel (15) zwischen einer ersten Position und einer zweiten Position verschiebbar und dichtend geführten Kolben (16) aufweist, der mit der Nadel (15) einen über die offene Nadelspitze (14) zugänglichen, volumenveränderlichen Aufnahmeraum (19) für das Medium bildet.

6. Dosiereinrichtung nach Anspruch 5,
dadurch **gekennzeichnet,**
daß Mittel vorgesehen sind, durch welche außen an der Nadel (15) anhaftendes Medium, insbesondere an der Nadelspitze (14) ausgebildete Tropfen, vermeidbar oder entfernbar ist.

7. Dosiereinrichtung nach Anspruch 5 oder 6,
dadurch **gekennzeichnet,**
daß der Kolben (16) mit seinem zur Nadelspitze (14) weisenden Ende (17) aus der Nadelöffnung (18) ausfahrbar und/oder innerhalb der Nadel (15) in mindestens eine weitere Position verschiebbar ist, um ein zusätzliches Aufnahmevolumen für ein weiteres Medium zu schaffen.

8. Dosiereinrichtung nach einem der Ansprüche 5 bis 7,
dadurch **gekennzeichnet,**
daß Mittel zur Erzeugung von Vibrationen und/oder zur Erwärmung der Nadel (15) vorgesehen sind, insbesondere Ultraschallerzeuger.

9. Dosiereinrichtung nach einem der Ansprüche 5 bis 8,
dadurch **gekennzeichnet,**
daß ein Depotsystem (25) vorgesehen ist, das einen Behälter (27) mit einer definierten Öffnung (26) aufweist, durch den die Nadel einbringbar ist, und welches insbesondere mit einer Druckeinrichtung versehen ist, um das Behälterinnere (28) unter Druck zu setzen.

10. Anordnung nach einem der vorhergehenden Ansprüche,
dadurch **gekennzeichnet,**
daß die Bestückungsmittel eine Verfahreinheit (10) mit einem Bestückungskopf (11) umfassen, welcher bevorzugt zur Aufnahme verschiedener Bauteilspitzen ausgebildet ist.

11. Anordnung nach einem der vorhergehenden Ansprüche,
dadurch **gekennzeichnet,**
daß Mittel zum automatischen Auftragen des Mediums und/oder Mittel zum automatischen Bestücken der Leiterplatte (4) mit Bauteilen (11) vorgesehen sind.

12. Anordnung nach einem der vorhergehenden Ansprüche,
dadurch **gekennzeichnet,**
daß das Einlegen und/oder Entnehmen der Leiterplatte (4) und/oder das Verschieben der Leiterplatte (4) zwischen den einzelnen Bearbeitungsstationen (A, B, C, D) manuell erfolgt.

13. Anordnung nach einem der vorhergehenden Ansprüche,
dadurch **gekennzeichnet,**
daß die Anordnung zumindest weitgehend aus an sich bekannten Einheiten und insbesondere modular aufgebaut ist.
